# EUROPEAN PATENT SPECIFICATION

(11) **EP 0 843 514 B1**
(45) Date of publication and mention of the grant of the patent: **18.06.2003**
(21) Application number: 97120210.6
(22) Date of filing: 18.11.1997
(51) Int. Cl.: H05K 13/04

(54) **Method and mounting apparatus for mounting a component**
Verfahren und Einrichtung zur Montage von Bauteilen
Méthode et appareil de montage de composants

(30) Priority: 18.11.1996 JP 30690996
(43) Date of publication of application: 20.05.1998
(73) Proprietor: YAMAHA HATSUDOKI KABUSHIKI KAISHA, Iwata-shi Shizuoka-ken, 438 (JP)
(72) Inventor: Hanamura, N., Iwata-Shi, Shizuoka-ken (JP)
(74) Representative: Grünecker, Kinkeldey, Stockmair & Schwanhäusser Anwaltssozietät

(56) References cited:
- GB-A- 2 183 820
- US-A- 5 329 692
- PATENT ABSTRACTS OF JAPAN vol. 095, no. 009, 31 October 1995 -& JP 07 162194 A (MATSUSHITA ELECTRIC IND CO LTD), 23 June 1995

## Description

This invention relates to a method and mounting apparatus for mounting a component on a specified position on a substrate.

A surface mounting machine or apparatus (thereafter referred to as "mounting machine") is generally known in which components are retrieved from a component supply unit by a movable head unit and are mounted on a substrate positioned for that purpose.

With this type of mounting machine, for instance, if specified components are being retrieved from a reel containing a tape stocked with components at specified intervals and guided to specified positions, the tape simply revolves in response to components being retrieved from a tape by the head unit. A number of these feeders, called tape feeders, are provided in the component supply unit, and components are supplied from said tape feeders.

Incidentally, with an apparatus such as that described above, it is necessary to replenish tapes when a tape runs out (components run out), and to conduct inspection of the tape if it fails to unwind properly, or if other problems occur. In conventional systems, the operator stopped the mounting machine, based on detection of a problem such as a tape running out, and replenished the tape and inspected the mounting machine. In this case, however, it was necessary that the mounting machine remain in stopped status until replenishment of the tape had been completed or correction of the problem had been concluded, and as tape replenishment was required with greater frequency, the operation rate of the mounting machine declined noticeably. Given this situation, as disclosed in patent posting 7-162194(1995), it is thought that the problem can be solved by providing a main component supply unit stocked with all types of components which are needed, along with an auxiliary component supply unit stocked with specific types of components which are used in the highest quantities and which are most likely to run out frequently. If the main component supply unit runs out of said specific types of components, those components are retrieved from the auxiliary component supply unit, so that components are supplied using the main and auxiliary component supply units in conjunction.

According to the above description, if an auxiliary component supply unit is provided and components mounted in the highest quantities are supplied from that supply unit, with said auxiliary component supply unit being used in conjunction with a main component supply unit, continuous operation is enabled, with components being supplied from either the main or the auxiliary component supply unit. As a result, the continuous operation rate is lengthened, and the replacement frequency is reduced, thus improving the mounting rate to some extent.

Even with the device disclosed in patent posting 7-162194 (1995), however, replacement of feeders and other maintenance procedures still need to be carried out during operation, and in the event that both the main and the auxiliary component supply units run out of components, it still remains necessary to stop the mounting machine, so that this point remains unchanged by the device disclosed here, and there is a limit as to how far the mounting rate can be improved.

GB-A-2 183 820 discloses a method and an apparatus for mounting components according to the prior art portions of claims 1 and 6.

Accordingly, it is an objective of the present invention to provide an improved method for mounting a component on a specified position on a substrate which enhances and elongates the mounting rate.

According to the present invention, this objective is solved by a method for mounting a component on a specified position on a substrate by picking up a respective component from one of a pair of component supply units from which components of the same types can be supplied by a movable head unit, said component supply units are opposing each other and consist of various and numerous feeders, said substrate is arranged between said component supply units'so that components are picked up from one component supply unit from one side and from the other component supply unit from the other side in case the one component supply unit is unable to supply the required components, whereat during the use of the other component supply unit the operation capability of the one component supply unit is restored.

Based on this method, in the event that components run out of the supply unit on one side or another problem occurs, mounting can be done immediately using components retrieved from the supply unit on the other side, and while components are being retrieved from that supply unit and mounted, replenishment of components and other maintenance and inspection work can be carried out on the first supply unit, which has run out of parts, or where another problem has occurred.

In order to further enhance the restoration of the operation capability, it is advantageous when the moving path of said head unit is such that an interference of the unused component supply unit is excluded.

By using this configuration, the head unit causes no interference when components are being replenished or other maintenance and inspection work is being carried out.

It is a further objective of the present invention to provide an improved mounting apparatus which, with simple technical means, enhances and elongates the mounting rate.

According to the present invention, this objective is solved by a mounting apparatus for mounting components on a specified position on a substrate, in particular for performing the method according to claim 1, comprising a movable head unit, a pair of opposing component supply units from which components of the same types are supplyable, said component supply units consisting of various and numerous feeders, said substrate being arrangable between said component supply units such that components are supplyable from one component supply unit from one side and from the other component supply unit from the other side in case the one component supply unit is unable to supply the required components, whereat during the use of one of said component supply units the operation capability of the other of said component supply unit is restorable

Based on this apparatus, in which the target supply unit from which components are to be retrieved by said head unit can be switched in response to a problem occurring which inhibits further supply of components, it becomes possible to implement the method of mounting described in Claim 1.

In order to further enhance the restoration of the operation capability, it is advantageous when the moving path of said head unit is restrictable such that an interference of the unused one of said component supply units is excludable.

According to an advantageous embodiment of the present invention, this mounting apparatus is provided with a main control unit for controlling a mounting operation.

According to an advantageous and preferred embodiment of the present invention, the changeover from one to the other of said component supply units is automatically controllable by a main control unit or manually controllable by an operator.

Using this apparatus, it becomes possible to automatically or manually retrieve and mount components from the other supply unit if a problem occurs with the first supply unit, such as components running out.

Using this apparatus enables manual switching of the target supply unit from which components are to be retrieved by said head unit.

Further, using this apparatus eliminates interference by the head unit when components are being replenished to the supply unit, or when other maintenance or inspection procedures are being carried out.

In addition, this apparatus provides an incentive for operators to replenish components and to carry out other maintenance and inspection procedures.

Moreover, using this apparatus improves operational procedures such as replenishment of components and other maintenance and inspection procedures.

Other preferred embodiments of the present invention are laid down in further dependent claims.

In the following, the present invention is explained in greater detail with respect to several embodiments thereof in conjunction with the accompanying drawings, wherein:
[Fig. 1] This is a schematic plan showing an example of a mounter (mounting machine) incorporating this invention.
[Fig. 2] This is a block diagram showing the control system of the mounter.
[Fig. 3] This is a flowchart showing the mounting operation as carried out by the mounter.
[Fig. 4] This is a flowchart showing the mounting operation as carried out by the mounter.
[Fig. 5] This is a typical drawing corresponding to the movable range of the head unit described in Fig. 1.

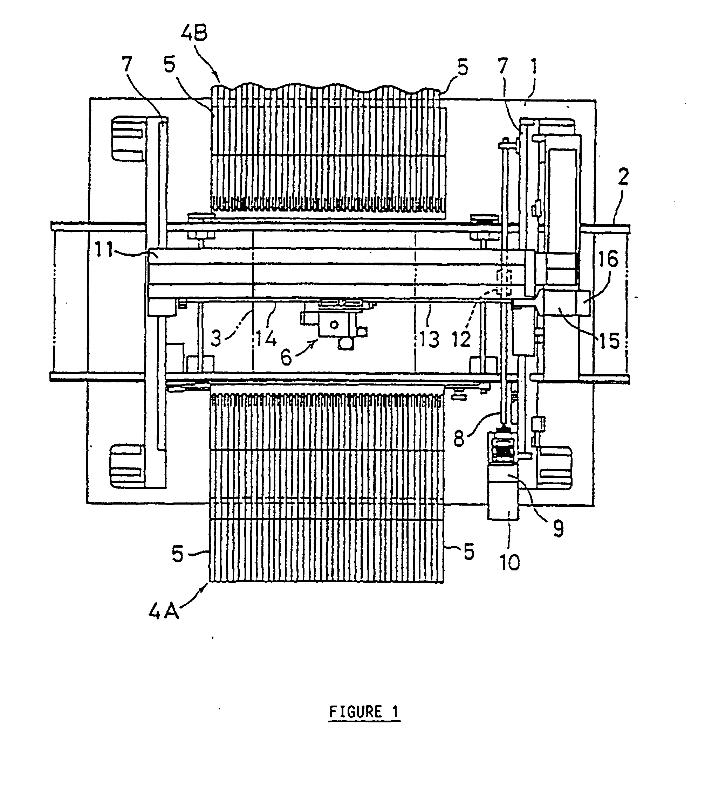

Fig. 1 shows a simplified view of the mounter (mounting machine) incorporating the equipment of this invention. As shown in the figure, on a bed 1 of the mounter is a conveyor 2 for conveying substrates, on which a substrate 3 is conveyed and halted at a given position (shown in the figure) for mounting work.

At the sides of the conveyor 2 there are positioned component supply units, and in the example shown here, a pair of component supply units consisting of a main supply unit 4A and an auxiliary supply unit 4B is positioned with the two supply units opposite each other and the conveyor 2 between them. These supply units 4A and 4B are equipped with numerous arrays of tape feeders 5, with each tape feeder 5 containing ICs, transistors, capacitors, and other fragmentary electronic components at spaced intervals. As the tape is drawn out from the reel on which it is stored, the components are retrieved by a head unit 6, described later, from a ratchet-type feed mechanism at the end of the tape, and the tape continues to be pulled out at intermittent intervals.

The supply units 4A and 4B are equipped with tape feeders 5 in order to supply all of the types of components required for mounting. The main supply unit 4A, in particular, contains numerous arrays of tape feeders 5 containing components which are mounted in high quantities, and thus which are consumed in a higher volume. The auxiliary supply feeder 4B may be equipped with tape feeders 5 in the same configuration as that of the main supply unit 4A, but tape feeders 5 may also be set up with one row of each type of component being supplied.

Upwards of the base 1 there is a head unit 6 for mounting components. This head unit 6 is movable in the X direction (the direction of the conveyor 2) as well as in the Y direction (the direction which intersects the X axis on the horizontal plane).

That is, on the bed 1 are arranged a pair of fixed rails 7 extending in the Y direction and a ball screw shaft 8 driven for rotation by a Y axis servo motor 9, and on the fixed rails 7 is positioned a head unit support member 11; a nut 12 provided in the support member 11 is fitted on the ball screw shaft 8. On the support member 11 are arranged a guide member 13 extending in the X direction and a ball screw shaft 14 driven by an X axis servo motor 15; the guide member 13 supports the head unit 6 to enable movement, and a nut (not shown) provided in the head unit 6 is fitted on the ball screw shaft 14. The ball screw shaft 8 rotates when the Y axis servo motor 9 operates, and the support member 11 moves in the Y axis direction, at the same time that the head unit 6 is moved in the X direction relative to the support member 11 when the X axis servo motor 15 operates as a result of the rotation of the ball screw shaft 14.

The Y axis servo motor 9 and X axis servo motor 15 are provided with encoders 10 and 16, respectively, for detecting the movement position of the head unit 6.

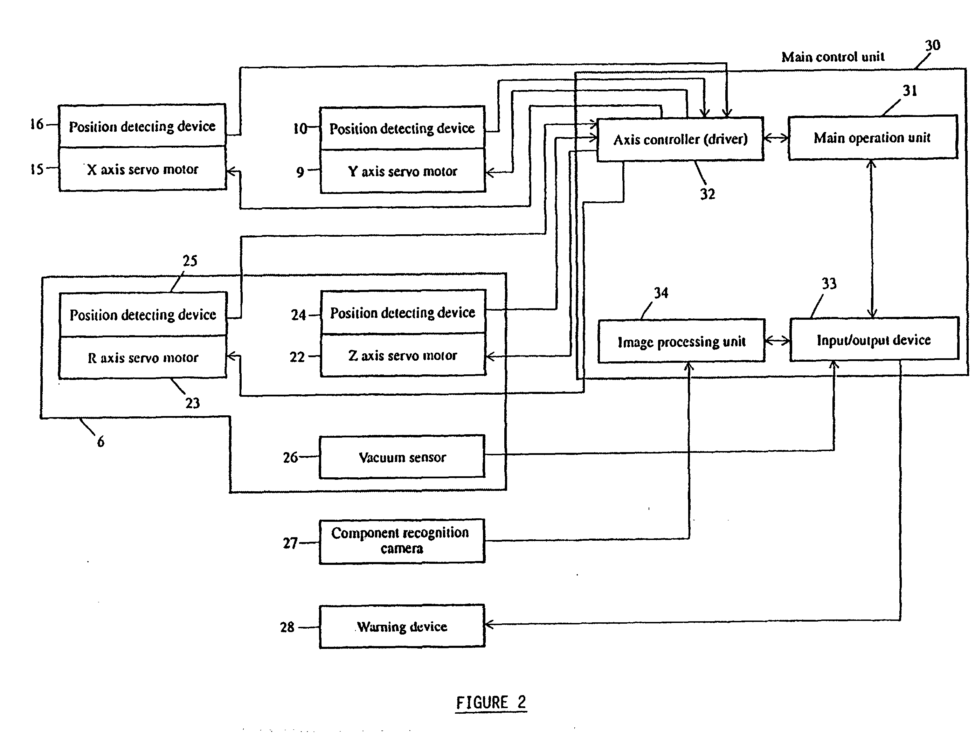

Said head unit 6 is equipped with nozzle members (not shown) which attract components. Said nozzle members are activated by a Z axis servo motor 22 and an R axis servo motor 23 (shown in Fig. 2, respectively) which enable movement in the Z axis direction (the perpendicular direction) and rotation in the R axis direction (axis rotation with the nozzle at the center) in relation to the frame of the head unit 6. In addition, the servo motors 22 and 23 are equipped with position detecting devices 24 and 25, which detect the position of the nozzle members.

The nozzle members are connected via a vacuum supply device and a vacuum supply tube (not shown), so that vacuum required in order to pick up components can be supplied to the nozzle members when needed. In addition, the vacuum supply tube is provided with a vacuum sensor 26 in the vicinity of the nozzle members, and presence detection (explained later) is carried out to find out whether or not a component has been picked up, based on the value detected by this vacuum sensor 26.

A component recognition camera 27 (shown in Fig. 2) is provided on the base 1, and when mounting is carried out, components retrieved from the supply devices 4A and 4B are imaged by this component recognition camera 27, and the components are recognized.

Next, the control system of said mounter is described, using the block diagram shown in Fig. 2 as a reference.

In the contrast to the above - mentioned Y axis servo motor 9, the X axis servo motor 15 and the nozzle members of the head unit 6, said mounter is equipped with the main control unit 30 shown in the figure, with the Z axis servo motor 22, the R axis servo motor 23 and the various position detecting devices 10, 16, 24, 25, and other components provided with these servo motors being connected electrically to the axis controller 32 of said main control unit 30.

The main control unit 30 is equipped with a main operation unit 31 which carries out overall control of the mounter, and said axis controller 32 is connected to this main operation unit 31. In addition, the main control unit 30 is equipped with an input/output device 33 which is connected to the main operation unit 31, with said vacuum sensor 26, lamps provided in the vicinity of the operation panel, and other warning devices 28 also being connected to the input/output device 33 as well. The image processing unit 34 is connected to the input/ output device 33, with the component recognition camera 27 being connected to the image processing unit 34 as well.

When mounting is carried out, said main operation unit 31 initiates drive control of the various servo motors through the axis controller 32, based on mounting data, meaning data relating to types of components to be mounted, mounting positions, mounting sequences and other factors, which has been stored in the memory unit (not shown). As the specified mounting operation is carried out, the component is recognized by the component recognition camera 37 during the mounting operation, and any offset in the position at which the component is picked up is detected by the main operation unit 31, based on the component recognition results which are, in turn, based on the image. Mounting of the component is then carried out allowing for offset in the mounting position and other factors.

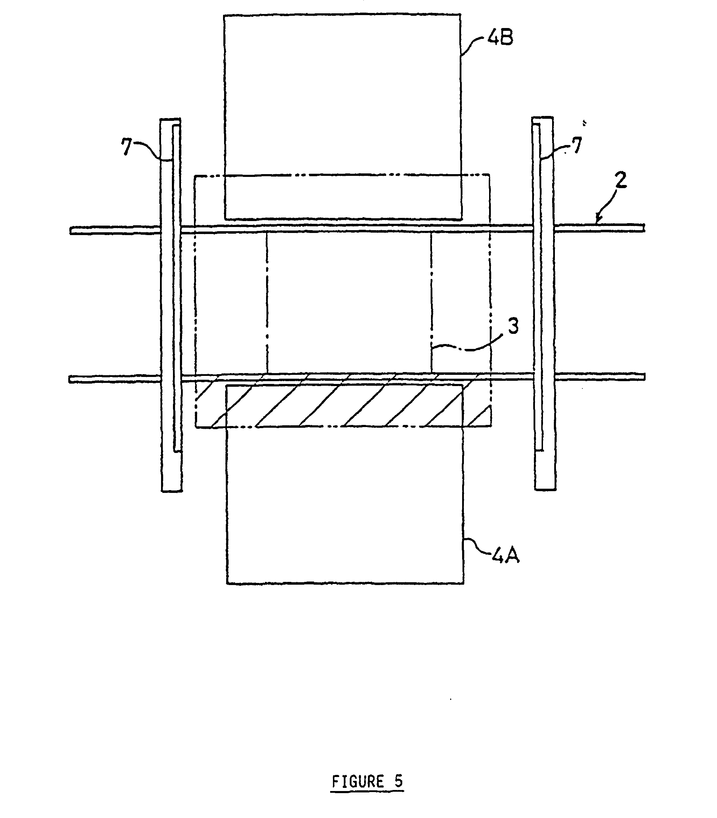

During the mounting operation, as described later, when components are being retrieved from only the main supply unit 4A and mounted, if mounting of components becomes impossible because the main supply unit 4A runs out of components, or for another reason, the main operation unit 31 controls the drive of the head unit 6 so that components are retrieved only from the auxiliary supply unit 4B and mounted. In particular, when components are retrieved only from the auxiliary supply unit 4B, the drive of the head unit 6 is controlled so that the head unit 6 does enter a given area. Specifically, the area including the component retrieval areas of both supply units 4A and 4B (the area encompassed by the lines intersected with double dots in Fig. 5) is the primary travel area of the head unit 6 but when component retrieval is being carried out only from the auxiliary supply unit 4B, the travel of the head unit 6 is restricted (prohibited) to the main supply unit 4A side (the area indicated by slanting lines in Fig. 5).

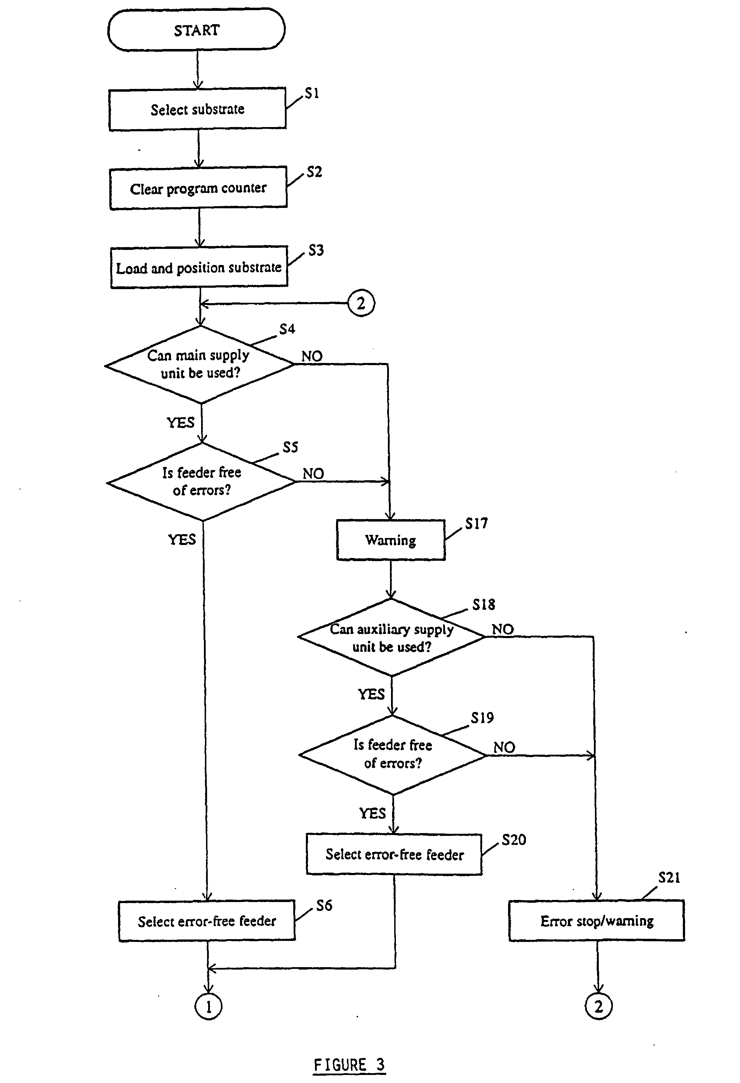

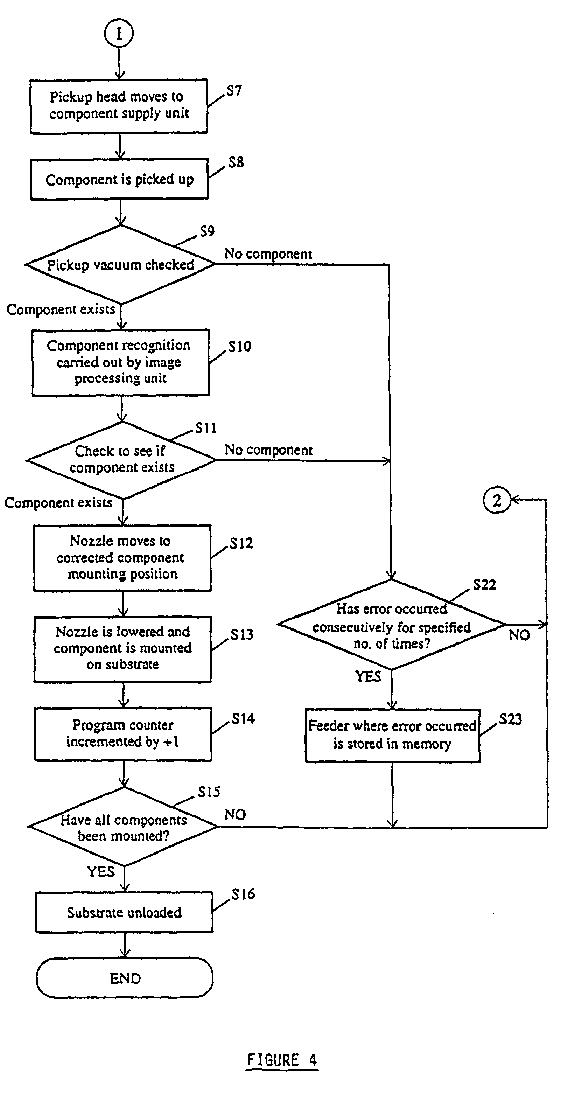

Next, in a mounter configured as described above, the mounting operation will be described in accordance with the flow charts shown in Figs. 3 and 4.

In the mounter described above, when mounting begins, first, the substrate data, namely the mount data, is read and the program counter is reset. Following that, the substrate 3 is loaded onto the conveyor 2 and is positioned at the work position described previously (steps S1 to S3).

Next, a judgment is made as to whether the main supply unit 4A can be used; namely, whether use of the main supply unit 4A is inhibited because a tape feeder 5 has been removed from the main supply unit 4A, or for other reasons making it physically impossible to use the main supply unit 4A. If it is possible to use the main supply unit 4A, operation advances to step S5 (step S4). In order to make this decision, detection is carried out by safety switches which determined whether or not a tape feeder 5 has been removed from the main supply unit 4A, and whether switches are on or off.

At step S5, a judgment is made as to whether an error such as the removal of a tape feeder from which components are retrieved in the main supply unit 4A is made; in other words, a decision is made as to whether component supply is impossible because the tape feeder 5 has run out of components, components have jammed, or for other reasons. In this case, if there is more than one tape feeder 5 containing the same type of components in the main supply unit 4A, a "NO" judgment results if all the these tape feeders 5 are in the status described above, and a "YES" judgment results if there is even one tape feeder 5 from which components can be supplied.

If the result at step S5 is "YES", the tape feeder 5 from which components can be supplied is selected, and the head unit 6 moves over the main supply unit 4A in response to the drive of the Y and X servo motors 9 and 15. Following that, the drive of the Z axis servo motor 22 causes the nozzle member to move upwards and downwards, so that components are picked up by the nozzle member and retrieved from the tape feeder 5 (steps S6 to S8).

At Step S9, confirmation is made as to whether or not a component has been picked up, based on the value detected by said vacuum sensor 26. At this time, if the value output by the vacuum sensor 26 is equal to or less than a threshold value set in advance, a judgment is made that a component has been picked up, and if the value is greater than the threshold value, a judgment is made that a component has not been picked up. In other words, a judgment is made that the tape feeder 5 has run out of components, components have jammed, or another problem has occurred, making component supply impossible.

If a decision is made at step S9 that a component has been picked up, the head unit 6 is activated so that recognition of the relevant component is made, and the attracted component is maintained-at the specified imaging position by the component recognition camera 27. The component is illuminated by an illumination device affixed to the component recognition camera 27, and an image of the component is formed by the image recognition camera 27. Recognition of the component is then carried out based on this image (step S10).

Confirmation is then carried out once again as to whether or not a component has been picked up, based on this component recognition, and if a judgment is made that a component has been picked up, any defect in the component or offset in the component pickup is detected based on the component recognition, and processing is carried out to determine the amount of correction required when the component is mounted (step S11). In the process by which the amount of correction is determined, for instance, the component image is scanned by the image processing unit 34, and based on this scan, the center position of the component and the rotation angle of the R axis are determined. Next, based on the positional offset from the center of the component and the rotational angle offset in relation to the point at which the component is attracted by the nozzle, the amount of correction is determined in the X and Y axis directions, and in the rotation direction.

Re-confirmation of whether or not a component has been picked up at step S11 is done to assure accurate detection of whether or not component supply is possible from the tape feeder 5, by judging whether or not a component exists, based on recognition of the image at step S11, because there is some concern that it may not be possible to judge at step S9 whether or not a component exists, because of foreign matter adhering to the nozzle member, or for other reasons.

If a judgment is made at step S11 that a component has been picked up, the component is placed at the proper position, taking the amount of correction and other factors into consideration, by the travel of the head unit 6 and the rotation of the nozzle member 21, and the component is mounted on the substrate 3 as the nozzle member 21 moves in the Z axis direction. At this time, the program counter is incremented (steps S13 and S14).

Next, a judgment is made as to whether or not all of the components have been mounted on the substrate 3, and if not, the process returns to step S4 and mounting of the next component begins. If all of the components have been mounted, the substrate 3 is unloaded, and the flow chart reaches its conclusion (steps S15 and S16).

If a "NO" judgment results from steps S4 and S5, the warning device 28 is activated, causing an alert to be issued to the operator that component supply has become impossible at the main supply unit 4A (step S17).

At steps S18 to S20, the same processing at that at steps S4 to S6 is carried out for the auxiliary supply unit 4B. Namely, a judgment is made as to whether or not components can be supplied from the auxiliary supply unit 4B, and if a judgment is made that components can be supplied, the tape feeder 5 is selected for the auxiliary supply unit 4B, and the process shifts to step S7.

If a judgment is made that it is impossible to supply components, the mounter is stopped, and the warning device 28 is activated (step S21). In other words, the operator is alerted that component supply has become impossible from both supply units 4A and 4B.

In steps S9 and S11, if a judgment is made that a component has not been picked up by a nozzle member, the process shifts to step S22, and a judgment is made as to whether or not consecutive errors have occurred for the relevant tape feeder 5 a number of times specified in advance; in other words, a judgment is made as to whether it has been impossible to pick up components for a specified consecutive number of times at steps S9 and S11. If the specified number of times has not been reached, the process shifts to step S4, and if the specified number of times has been reached, the process shifts to step S23, and the relevant tape feeder 5 is stored in the memory. Namely, if there are several tape feeders 5 supplying the same type of component, storing the tape feeder 5 which has run out of components or for which another problem has occurred in memory provides feedback for the processing at steps S5 and S6, or at steps S9 and S20.

In the mounter described here, a main supply unit 4A and an auxiliary supply unit 4B are provided which enable the components necessary for mounting to be supplied, and mounting is carried out through a head unit 6 which retrieves the components from the main supply unit 4A only. If component supply becomes impossible from the main supply unit 4A, or if errors have occurred with respect to all of the tape feeders 5 from which the target components are being supplied, component retrieval is carried out by the head unit 6 from the auxiliary supply unit 4B only, so that components can continued to be mounted continuously on the substrate 3 without stopping the mounter even if the main supply unit 4A runs out of components or another problem occurs which makes component supply impossible from the main supply unit 4A.

In addition, because the main supply unit 4A and the auxiliary supply unit 4B are positioned on opposite sides with the substrate 3 between them, the interval in which components are being supplied from the auxiliary supply unit 4B can be used to refill tape feeders 5 in the main supply unit 4A and to carry out maintenance and inspection operations. In particular, with the mounter described here, during the time that components are being retrieved from the auxiliary supply unit 4B, the head unit 6 is prevented from moving towards the main supply unit 4A side, increasing the speed and safety of maintenance and inspection operations carried out on that side.

Consequently, using this mounter, component replenishment and other maintenance and inspection operations can be carried out without interrupting the mounting operation, and in comparison with conventional mounters, in which it was necessary to stop the mounting operation if a problem occurred such as components running out, it is possible to effectively avoid a lowering of the mounting rate.

The mounter with the implementation configuration described above is one example of a mounter incorporating this invention. The specific configuration of the mounter may be changed as appropriate, within a range which does not depart from the overall gist of this invention.

For instance, with the implementation configuration described above, during the time that components are being retrieved by the head unit 6 from the auxiliary supply unit 4B, the servo motors or other devices are controlled by the main operation unit 31 such that the head unit 6 does not move to the main supply unit 4A side; in other words, this invention is designed in such a way that the main operation unit 31 overlaps the function of the regulating means provided in this invention, but a stopper or other means may be provided to regulate the movable range of the head unit 6 in a mechanical manner as a means of regulation.

In addition, during the time that components are being retrieved by the head unit 6 from the main supply unit 4A, the head unit 6 may be restricted from moving to the auxiliary supply unit 4B side. This system offers the advantage that component replenishment and other maintenance and inspection operations can be carried out more quickly and more safely with regard to the tape feeders 5 of the auxiliary supply unit 4B while mounting is in progress.

Furthermore, in a mounter with the implementation configuration described above, if the main supply unit 4A cannot be used, or if errors have occurred for all of the tape feeders 5 from which the relevant components are being supplied, causing a status in which component supply is impossible from the main supply unit 4A, control is initiated automatically so that the head unit 6 retrieves components from the auxiliary supply unit 4B. For instance, however, a switch may be provided which enables the operator to switch to manual operation following an alert based on the warning device 28 at step S17, which switches the retrieval of components by the head unit 6 from the main supply unit 4A to the auxiliary supply unit 4B.

Although it has not been described in particular in the implementation configuration described here, it would also be possible, for instance, to position all of the tape feeders 5 for both supply units 4A and 4B at the side of the conveyor 2 (in Fig. 1, with the main supply unit 4A on the lower side and the auxiliary supply unit 4B on the upper side). With this configuration, because the tape feeders 5 can be maintained at positions farther away from the movable range of the head unit 6, components can be replenished in the tape feeders 5 and other maintenance and inspection operations can be carried out more easily.

As described above, in a system in which components are retrieved from supply units by a movable head unit and mounted on substrates, a pair of supply units is provided from which components of the same type can be supplied, and these supply units are positioned across from each other on either side of the substrate, with components being retrieved by the head unit from the supply unit on one side. If component supply becomes impossible from the relevant supply unit, components can be retrieved by the head unit from the supply unit on the other side, so that if the supply unit on one side runs out of components, or another problem occurs, components can immediately be retrieved from the supply unit on the other side and mounted. Also, while components are being retrieved from the supply unit on the other side, components can be restocked in the supply unit on the first side, and other maintenance and inspection operations can be carried out. For this reason, even if a problem such as parts running out occurs, mounting operation can be continued, and a drop in the mounting rate can be effectively avoided.

In particular, if mounting is carried out with components being retrieved only from the supply unit on one side or the other, if the head unit is prevented from moving to the side on which the supply unit from which components are not being supplied is positioned, replenishment of components if components run out, and other maintenance and inspection procedures can be carried out without interference from the head unit, which results in the work being done more quickly and more safely.

## Claims

1. Method for mounting a component on a specified position on a substrate (3) by picking up a respective component from one of a pair of component supply units (4A,4B) from which components can be supplied by a movable head unit (6), said component supply units (4A,4B) are opposing each other and consist of various and numerous feeders (5), said substrate (3) is arranged between said component supply units (4A,4B) **characterised in that** components of the same types can be supplied from the pair of supply units, so that components are picked up from one component supply unit (4A) from one side and from the other component supply unit (4B) from the other side in case the one component supply unit (4A) is unable to supply the required components, whereat during the use of the other component supply unit (4B) the operation capability of the one component supply unit (4A) is restored.

2. Method according to claim 1, **characterized in that** the moving path of said head unit (6) is such that an interference of the unused component supply unit (4A or 4B) is excluded.

3. Method according to claim 1 or 2, **characterized in that** said mounting operation is controlled by a main control unit (30).

4. Method according to claim 3, **characterized in that** said main control unit (30) controls said mounting operation based on prestored mounting data, meaning data relating to types of components, mounting positions, mounting sequences and other related factors.

5. Method according to at least one of the preceding claims 1 to 4, **characterized in that** the changeover from the one component supply unit (4A) to the other component supply unit (4B) is carried out automatically or manually upon an alert.

6. Mounting apparatus for mounting components on a specified position on a substrate (3), in particular for performing the method according to claim 1, comprising a movable head unit (6), a pair of opposing component supply units (4A,48) from which components are supplyable, said component supply units (4A,4B) consisting of various and numerous feeders (5), said substrate (3) being arrangable between said component supply units (4A,4B) **characterised in that** components of the same types can be supplied from the pair of supply units, such that components are supplyable from one component supply unit (4A) from one side and from the other component supply unit (4B) from the other side in case the one component supply unit (4A) is unable to supply the required components, whereat during the use of one of said component supply units (4A,4B) the operation capability of the other of said component supply unit (4B,4A) is restorable.

7. Mounting apparatus according to claim 6, **characterized in that** the moving path of said head unit (6) is restrictable such that an interference of the unused one of said component supply units (4A,4B) is excludable.

8. Mounting apparatus according to claim 6 or 7, **characterized by** a main control unit (30) for controlling a mounting operation.

9. Mounting apparatus according to claim 8, c**haracterized in that** said main control unit (30) being capable of controlling said mounting operation based on prestored mounting data, meaning data relating to types of components, mounting positions, mounting sequences and other related factors.

10. Mounting apparatus according to at least one of the preceding claims 6 to 9, **characterized in that** the changeover from one to the other of said component supply units (4A,4B) is automatically controllable by a main control unit (30) or manually controllable by an operator.

## Patentansprüche

1. Verfahren zum Montieren eines Bauteiles an einer bestimmten Position auf einem Substrat (3) durch Aufnehmen eines jeweiligen Bauteiles von einem Paar von Bauteilzuführungseinheiten (4A, 4B) von denen Bauteile durch eine bewegbare Kopfeinheit (6) zugeführt werden können, wobei die Bauteilzuführungseinheiten (4A, 4B) einander gegenüberliegend sind und aus verschiedenen und zahlreichen Zuführvorrichtungen (5) bestehen, das Substrat (3) zwischen den Bauteilzuführungseinheiten (4A, 4B) angeordnet ist, **dadurch gekennzeichnet, dass** Bauteile desselben Typs von dem Paar von Zuführungseinheiten zugeführt werden können, so dass Bauteile von einer Bauteilzuführungseinheit (4A) von einer Seite und von der anderen Bauteilzuführungseinheit (4B) von der anderen Seite für den Fall aufgenommen werden können, dass die eine Bauteilzuführungseinheit (4A) nicht in der Lage ist, die erforderlichen Bauteile zuzuführen, wobei während des Gebrauchs der anderen Bauteilzuführungseinheit (4B) die Betriebsfähigkeit der einen Bauteilzuführungseinheiten (4A, 4B) wiederhergestellt wird.

2. Verfahren nach Anspruch 1, **dadurch gekennzeichnet, dass** der Bewegungspfad der Kopfeinheit (6) derart ist, dass eine Störung der nichtverwendeten Bauteilzuführungseinheit (4A oder 4B) ausgeschlossen wird.

3. Verfahren nach Anspruch 1 oder 2, **dadurch gekennzeichnet, dass** der Montagevorgang durch eine Hauptsteuereinheit (30) gesteuert wird.

4. Verfahren nach Anspruch 3, **dadurch gekennzeichnet, dass** die Hauptsteuereinheit (30) den Montagevorgang auf der Grundlage von voreingespeicherten Montagedaten steuert, d. h. von Daten, die sich auf die Arten der Bauteile, Montagepositionen, Montagefolgen und andere betreffende Faktoren beziehen.

5. Verfahren nach zumindest einem der vorhergehenden Ansprüche 1 bis 4, **dadurch gekennzeichnet, dass** der Wechsel von einer Bauteilzuführungseinheit (4A) zu der anderen Bauteilzuführungseinheit (4B) auf Grund eines Warnsignales automatisch oder manuell ausgeführt wird.

6. Montagevorrichtung zum Montieren von Bauteilen auf einer bestimmten Position auf einem Substrat (3), insbesondere zum Ausführen des Verfahrens nach Anspruch 1, mit einer bewegbaren Kopfeinheit (6), einem Paar von gegenüberliegenden Bauteilzuführungseinheiten (4A, 4B), von denen Bauteile zuführbar sind, wobei die Bauteilzuführungseinheiten (4A, 4B) aus verschiedenen und zahlreichen Zuführvorrichtungen (5) bestehen, die zwischen den Bauteilzuführungseinheiten (4A, 4B) anordenbar sind, **dadurch gekennzeichnet, dass** Bauteile derselben Art von dem Paar der Zuführeinheiten derart zugeführt werden können, dass die Bauteile von einer Bauteilzuführungseinheit (4A) von einer Seite und von der anderen Bauteilzuführungseinheit (4B) von der anderen Seite für den Fall zugeführt werden können, dass die eine Bauteilzuführungseinheit (4A) nicht in der Lage ist, die erforderlichen Bauteile zuzuführen, wobei während des Gebrauchs der einen der Bauteilzuführungseinheiten (4A, 4B) die Betriebsfähigkeit der anderen der Bauteilzuführungseinheiten (4B, 4A) wiederherstellbar ist.

7. Montagevorrichtung nach Anspruch 6, **dadurch gekennzeichnet, dass** der Bewegungspfad der Kopfeinheit (6) derart begrenzbar ist, dass eine Störung der nichtverwendeten der Bauteilzuführungseinheiten (4A, 4B) ausgeschlossen ist.

8. Montagevorrichtung nach Anspruch 6 oder 7, **gekennzeichnet durch** eine Hauptsteuereinheit (30) zum Steuern des Montagevorganges.

9. Montagevorrichtung nach Anspruch 8, **dadurch gekennzeichnet, dass** die Hauptsteuereinheit (30) in der Lage ist, den Montagevorgang auf der Grundlage von voreingespeicherten Motagedaten zu steuern, d. h. von Daten, die sich auf die Arten von Bauteilen, Montagepositionen, Montagefolgen und andere betreffende Faktoren beziehen.

10. Montagevorrichtung nach zumindest einem der vorhergehenden Ansprüche 6 bis 9, **dadurch gekennzeichnet, dass** der Wechsel von einer zu der anderen der Bauteilzuführungseinheiten (4A, 4B) durch eine Hauptsteuereinheit (30) steuerbar oder durch einen Bediener manuell steuerbar ist.

## Revendications

1. Procédé de montage d'un composant sur une position spécifiée sur un substrat (3) en retirant un composant respectif de l'une d'une paire d'unités de fourniture de composants (4A, 4B) à partir desquelles les composants peuvent être fournis par une unité principale (6) pouvant être déplacée, lesdites unités de fourniture de composants (4A, 4B) s'opposent l'une l'autre et se composent de dispositifs de fourniture variés et nombreux (5), ledit substrat (3) est disposé entre lesdites unités de fourniture de composants (4A, 4B), **caractérisé en ce que** les composants des mêmes types peuvent être fournis à partir de la paire d'unités de fourniture, de telle sorte que les composants sont retirés d'une unité de fourniture de composants (4A) d'un côté et de l'autre unité de fourniture de composants (4B) de l'autre côté au cas où l'une des unités de fourniture de composants (4A) ne serait pas en mesure de fournir les composants nécessaires, tandis que pendant l'utilisation de l'autre unité de fourniture de composants (4B), la capacité de fonctionnement de ladite unité de fourniture de composants (4A) est restaurée.

2. Procédé selon la revendication 1, **caractérisé en ce que** la trajectoire de déplacement de ladite unité principale (6) est telle qu'une interférence de l'unité de fourniture de composants inutilisée (4A, 4B) est exclue.

3. Procédé selon la revendication 1 ou 2,
**caractérisé en ce que** ladite opération de montage est commandée par une unité de commande principale (30).

4. Procédé selon la revendication 3, **caractérisé en ce que** ladite unité de commande principale (30) commande ladite opération de montage sur la base de données de montage préenregistrées, ce qui signifie les données liées aux types de composants, aux positions de montage, aux séquences de montage et autres facteurs connexes.

5. Procédé selon au moins une quelconque des revendications précédentes 1 à 4, **caractérisé en ce que** le passage de l'une des unités de fourniture de composants (4A) à l'autre unité de fourniture de composants (4B) est effectué automatiquement ou manuellement sur une alerte.

6. Appareil de montage de composants sur une position spécifiée sur un substrat (3), en particulier pour exécuter le procédé selon la revendication 1, comprenant une unité principale (6) pouvant être déplacée, une paire d'unités de fourniture de composants s'opposant (4A, 4B) à partir desquelles les composants peuvent être fournis, lesdites unités de fourniture de composants (4A, 4B) se composant de dispositifs d'alimentation variés et nombreux (5), ledit substrat (3) pouvant être disposé entre lesdites unités de fourniture de composants (4A, 4B), **caractérisé en ce que** les composants des mêmes types peuvent être fournis à partir de la paire d'unités, de telle sorte que les composants peuvent être fournis à partir d'une unité de fourniture de composants (4A) d'un côté et de l'autre unité de fourniture de composants (4B) de l'autre côté au cas où ladite unité de fourniture de composants (4A) ne serait pas en mesure de fournir les composants nécessaires, tandis que pendant l'utilisation de l'une desdites unités de fourniture de composants (4A, 4B), la capacité de fonctionnement de l'autre de ladite unité de fourniture de composants (4B, 4A) peut être restaurée.

7. Appareil de montage selon la revendication 6, **caractérisé en ce que** la trajectoire de ladite unité principale (6) peut être restreinte, de telle sorte qu'une interférence de celle inutilisée desdites unités de fourniture de composants (4A, 4B) peut être exclue.

8. Appareil de montage selon la revendication 6 ou 7, **caractérisé par** une unité de commande principale (30) destinée à commander l'opération de montage.

9. Appareil de montage selon la revendication 8, **caractérisé en ce que** ladite unité de commande principale (30) est capable de commander ladite opération de montage sur la base de données de montage préenregistrées, ce qui signifie les données liées aux types de composants, aux positions de montage, aux séquences de montage et autres facteurs connexes.

10. Appareil de montage selon au moins l'une quelconque des revendications 6 à 9, **caractérisé en ce que** le passage de l'une à l'autre desdites unités de fourniture de composants (4A, 4B) peut être commandé automatiquement par une unité de commande principale (30) ou commandé manuellement par un opérateur.
